# EUROPEAN PATENT APPLICATION

(11) **EP 4 530 722 A2**
(43) Date of publication of application: **02.04.2025**
(21) Application number: 24195966.7
(22) Date of filing: 22.08.2024
(51) Int. Cl.: G03F 7/11, G03F 7/075, G03F 7/38

(54) **SWITCHABLE UNDERLAYERS FOR EUV LITHOGRAPHY**

(30) Priority: 29.09.2023 US 202318375031
(71) Applicant: INTEL Corporation, Santa Clara, CA 95054 (US)
(72) Inventor: JORDAN, Robert, Portland, OR 97221 (US); HOLYBEE, Brandon, Portland, OR 97203 (US); BLACKWELL, James, Portland, OR 97201 (US); BLUESTEIN, Blake, Hillsboro, OR 97123 (US); MATTSON, Eric, Portland, OR 97225 (US); KRYSAK, Marie, Portland, OR 97225 (US); GUZMAN, Nicole, Newberg, OR 97132 (US); HARLSON, Shane, Beaverton, OR 97003 (US); HAN, Eungnak, Portland, OR 97229 (US); GSTREIN, Florian, Portland, OR 97212 (US)
(74) Representative: HGF

(57) **Abstract**

Provided are methods and compounds for using an adhesively switchable underlayer beneath a photoresist in a lithographic process for making a semiconductor wafer.

## Description

### TECHNICAL FIELD

The present disclosure generally relates to semiconductor lithography and more particularly to structures including or formed using a photoresist underlayer and to methods of forming such structures.

### BRIEF DESCRIPTION OF THE DRAWINGS

Fig. 1 is a diagram schematically illustrating a portion of a conventional lithographic manufacturing process for a semiconductor device.
Fig. 2 is a flow diagram showing a part of a lithographic process using a CAR (chemically amplified resist) with a SUL (switchable underlayer) in accordance with some embodiments.
Fig. 3A is a diagram schematically illustrating wafer stages using the process of Fig. 2 in accordance with some embodiments.
Fig. 3B is a schematic view of the wafer of Fig. 3A, illustrating SUL grafting and switchable adhesion structures in accordance with some embodiments.
Fig. 4 is a diagram showing surface energy analysis of a SUL pre and post EUV processing as compared with other UL materials in accordance with some embodiments.
Fig. 5 is a diagram showing exemplary SUL molecule structures in accordance with some embodiments.

### DETAILED DESCRIPTION

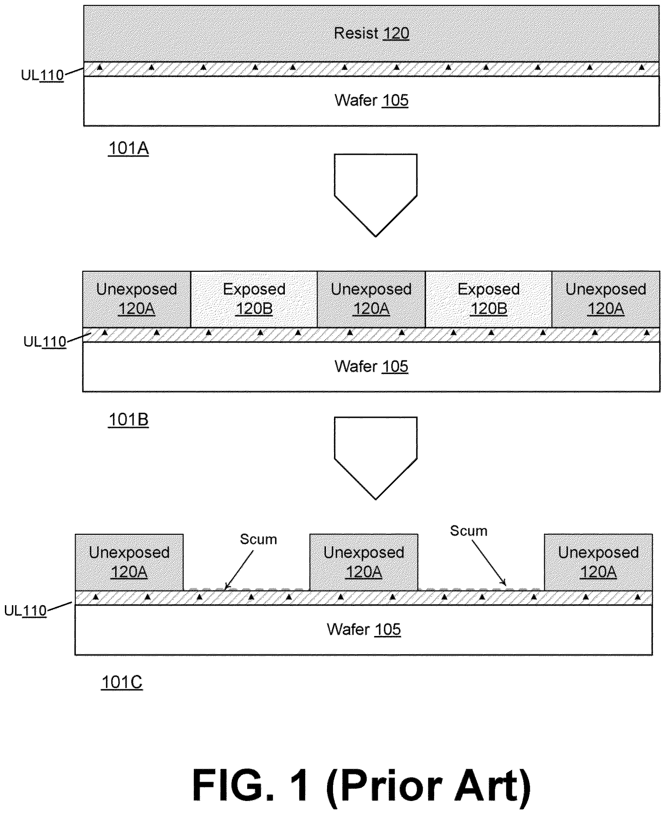

Fig. 1 is a diagram schematically illustrating a portion of a conventional lithographic manufacturing process for a semiconductor device. During the manufacture of semiconductor devices, fine patterns of features can be formed on a surface of a substrate 105 by patterning the surface of the substrate and etching material from the substrate surface using, for example, gas-phase etching processes. As a density of devices on a substrate increases, it becomes increasingly desirable to form features with smaller dimensions.

As shown at 101A, a photoresist (resist) layer 120 is used to pattern a surface of a substrate prior to etching. The resist layer 120 is applied to a surface of the substrate 105, usually on top of an underlayer material 110, which among other things, serves as an adhesive to adhere the photoresist to the substrate surface.

The photoresist is then exposed to radiation from a mask having a desired feature pattern. Techniques have recently been developed to use extreme ultraviolet (EUV) wavelengths to develop patterns having relatively small pattern features (e.g., 10 nm or less). The radiation (EUV) pattern is projected onto the resist, exposing the pattern, or non-pattern, portions, depending on whether a positive or negative resist material is used. From here, either the exposed (positive) or non-exposed (negative) portions are removed using a developer. This is represented at 101B. With this example, a positive resist is used where the exposed portions are removed. Thus, as shown at 101C, the exposed resist portions 120B are removed. This is referred to as the development step.

Most of the EUV photoresists (resists) used today are chemically amplified resists (CARs). In contrast with other photoresist materials, within a CAR incoming light does not directly cause the backbone polymer to become soluble. Rather, the light is absorbed by photoacid generators (PAGs), which release multiple photoacid molecules per photon. The photoacid reacts with protective groups on the polymer backbone, "de-protecting" it and causing it to become soluble in developer solution (e.g., aqueous development solution). With EUV resists, the incoming light can also excite photoelectrons, which in turn can also drive the photoacid generation reaction.

Unfortunately, after development, as illustrated at 101C, wet development of chemically amplified resists (CARs) often leaves behind significant amounts of unwanted material (`scum') within the exposed region, which has necessitated aggressive plasma-based descum processes. This can be problematic, for example, because the plasma also detrimentally eats away at the unexposed photoresist. One of the main problems is that the underlayer should provide good photoresist adhesion in order to achieve satisfactory lithographic feature definition and sufficient process windows for good patterning, but increased resist-underlayer adhesion also gives rise to an increase in resist scum remaining. Complicating this further, as resists need to be increasingly thinner as feature sizes and pitches become smaller, the ability to use etch or descum processes becomes much more limited and post-etch defectivity begins to dominate - resist scum is not as effectively removed and leads to greater bridge defects (scum was not fully removed) or line break defects (descum/etch process begins to destroy the resist lines). Another significant disadvantage comes with the selection of typical underlayers that need to perform well with resist (good resist adhesion) but also need good etch performance to transfer the resist pattern into the underlayer and etch stack below. Accordingly, some embodiments disclosed herein describe underlayer approaches to address these challenges.

In some embodiments, a switchable underlayer (SUL) is provided that gives strong resist adhesion to promote patterning performance but also can utilize the built-in photoacid generation from CARs (chemically amplified resists) to promote an adhesion switch at the resist/underlayer interface. The SUL has molecules that switch from being resist-philic to resist-phobic upon EUV exposure, producing an underlayer that facilitates more effective development and scum removal, requiring less aggressive de-scumming.

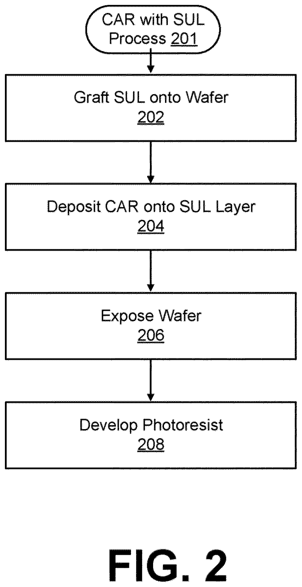

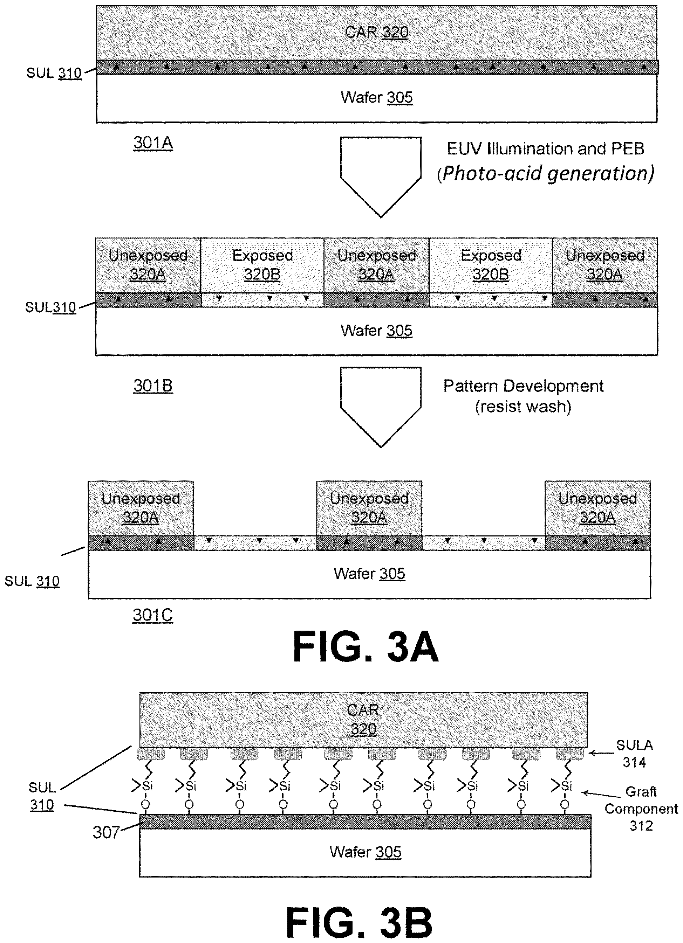

With reference to Figs. 2, 3A, and 3B, a portion of a lithographic process using a CAR with a switchable underlayer (SUL) will be described. Fig. 2 is a flow diagram showing a part of a lithographic process using a CAR with a SUL in accordance with some embodiments. Fig. 3A is a diagram schematically illustrating wafer stages using the process of Fig. 2 in accordance with some embodiments. Fig. 3B is a schematic view of the wafer of Fig. 3A, illustrating a SUL grafting and switchable adhesion structure, in accordance with some embodiments.

At 202, a thin SUL layer (e.g., a mono-molecular layer) 310 is grafted onto the surface of a wafer 305. (Composition and properties of a SUL material is discussed in more detail below.) The SUL may be grafted to the wafer surface using any suitable approach. For example, it may be done with several different techniques. It could be applied using a spin-coating method, e.g., in a similar fashion to how the CAR (hereinafter referred to as CAR or resist) is deposited. However, this approach may not be ideal because, for example, vapor from the SUL can leave deposits causing issues for subsequent coating applications and may not provide desired adhesion of the resist.

Another approach is to use a vapor phase deposition (VPD) method. For example, a vacuum deposition system could be employed. With such a system, the vacuum can be used to pull in a controlled amount of SUL, typically being suited to apply it equally over the wafer surface. Another benefit of using a VPD method is that it causes the SUL to be grafted onto the surface as it is applied without having to be baked, as would likely be the case with a spin coat application.

Fig. 3B illustrates a structure for grafting (or anchoring) the SUL onto the wafer surface in accordance with some embodiments. It should be appreciated that the approach, and chemical grafting mechanism, will depend on the make-up of the actual surface to which the SUL is being applied. In this example, the wafer surface 307 is formed from an oxide or nitride such as silicon oxide or silicon nitride, which, for example, as a result of the surface hydroxyl groups, will exhibit a poor affinity for the non-polar or low-polar molecules of the resist. Therefore, the SUL needs a way to form an adhesive bridge between the polar wafer surface and non-polar resist material. In some embodiments, the SUL may be formed from a SUL molecule having, among other things, a grafting component, and an adhesive component. This is illustrated in Fig. 3B with the SUL 310 including a Si-O grafting component 312 and a SUL adhesive (SULA) component 314. The Si-O grafting component 312, as shown, anchors itself to the wafer's Si-O2 surface, forming strong bonds with the embedded hydroxyl groups. Likewise, at least prior to exposure, the SULA component 314 provides non-polar head groups that can be adhered to by the resist 320. Prior to EUV processing, the SULA head groups display strong adhesive forces for the resist, improving patterning and preventing line collapse.

From here, at 204 (Fig. 2), the CAR is applied atop the SUL. As with the application of SUL, the CAR may be deposited using any suitable method such as spin coating or vapor phase deposition.

With reference to Fig. 3A, at 301A, the CAR 320 has been applied, and the wafer is ready for exposure. From here (206/301A), the resist is illuminated (exposed), e.g., from EUV radiation projected off of an EUV mask. It then goes through a post exposure bake (PEB) stage, e.g., 120 degrees C for 1 minute. Among other things, the PEB energizes the photoacids created from the EUV photons and breaks down the exposed CAR structure (polymer deprotection). During this post exposure bake, the energized CAR photoacids also switch the SUL molecules under the exposed CAR portions (e.g., cleave away the adhesive components from the SUL molecules) to produce the lower adhesivity state of the SUL. The head groups within the exposed SUL regions undergo switching to reveal resist-phobic functional groups ('mis-matched' interface), which aids in the full removal of resist and decreases scumming.

In essence, the switching reactions are piggy-backed off of the photoacids that are already being created by the CAR during exposure. Note, however, that in other embodiments, the adhesive components could be removed by reactants (e.g., acids) generated within the SUL material itself from impinging photons and/or by-product electrons during exposure. For example, in some embodiments, active photoacid generating components used by the CAR could be incorporated into the SUL material itself.

The exposed and baked wafer is depicted at 301B. There are unexposed CAR portions 320A and exposed CAR portions 320B. Likewise, there are switched SUL portions (lighter shading) that are directly beneath the exposed CAR portions 320B. In contrast, the SUL portions beneath the unexposed CAR portions 320A are unaffected, not "switched" as indicated by darker shading.

At 208, the resist is developed. The structural polymer breakdown of the exposed CAR portions allows them to be soluble in a wash solution, e.g., an aqueous wash solution that can remove the exposed CAR material, as is indicated at 301C. With the use of the SUL, very little, if any, CAR scum remains after this development stage, in many cases, avoiding the need to perform a further step of de-scumming such as with a plasma descum step.

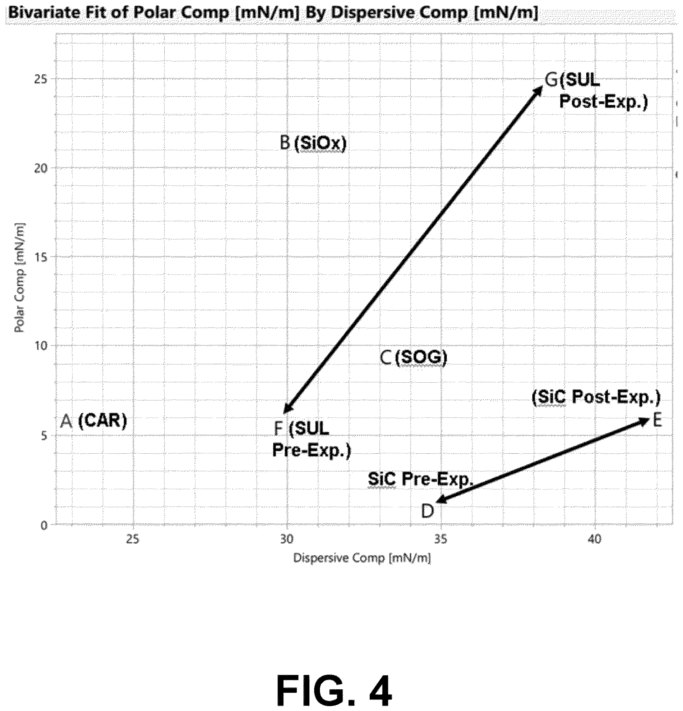

Figure 4 is a diagram showing surface energy analysis of a SUL pre and post EUV processing as compared with other common UL materials (SiC, SiOx, spin-on-glass (SOG)). As shown, a SUL material can undergo a relatively large change in surface energy upon EUV processing, which provides evidence that the switching of the head groups is working as designed. In fact, as shown, water and diiodomethane contact angle measurements taken before and after EUV processing showed dramatic changes in surface energy within the exposed regions. In these measurements, it was shown that for pre-exposure, the SUL material displayed a dispersive component value of 30 mN/M and a polar component value of 6 mN/M, similar to the CAR's properties (indicated at 'A'), which produces strong adhesive forces improving patterning and preventing line collapse. On the other hand, for post-exposure, the SUL surface energy dramatically shifted with a dispersive component value of 38 mN/M and a polar component value of 25 mN/M, far away from the CAR, lowering the adhesive forces and making removal by the developer more energetically favorable. Work of adhesion analysis of SUL materials has demonstrated a 53% drop in adhesion from pre to post exposure/bake.

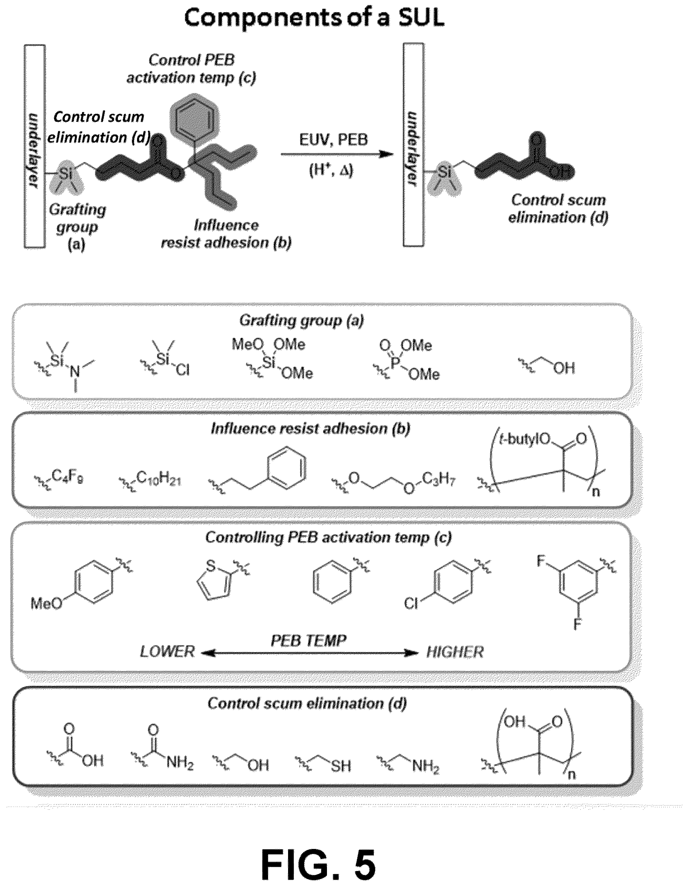

Fig. 5 is a diagram showing exemplary SUL molecule structures in accordance with some embodiments. As shown, a SUL molecule may include a grafting group component (a), a resist adhesion component (b), a PEB activation-temperature control component (c), and a scum elimination control component (d). The grafting component (a) should be able to graft (or anchor) the molecule to the wafer surface being processed. For example, with silicon oxide or nitride surfaces, a grafting group could include but is not limited to: silyl amides, silyl chlorides, trialkoxy silanes, phosphonates and alcohols.

The component for influencing resist adhesion should be chosen in connection with the utilized CAR. For example, component groups used for a resist adhesion component could include but are not limited to: alkanes, pefluoroalkanes, aryl groups, polygylcols and polymers.

The PEB activation-temperature control component should be selected to cause or allow the adhesion component to be cleaved from the SUL molecule within a range encompassing the utilized PEB temperature. For example, in some embodiments with a PEB temperature of 120 degrees C, the activation-temperature component might facilitate switching (e.g., deprotecting and cleaving of adhesion component) at a temperature of 120 degrees C, as well as at a temperature in a range of between 115 and 125 degrees C. The activation temperature should accommodate the temperature selected based on the utilized CAR. As shown in the diagram (c), a component used for PEB activation temperature may be chosen from a group including but not limited to: aryl and heteroaryl rings substituted with electron donating substituents (e.g., methoxy, amino) or electron withdrawing substituents such as fluorine and nitro groups.

A scum elimination component should remain after exposure/PEB and should have sufficiently low adhesion with the utilized CAR material. For example, a scum elimination component could be selected from a group including but not limited to carboxylates, amides, alcohols, thiols, amines and polymers.

An ideal SUL molecule (SUL) should be highly adhesive to the resist in its' pre-exposure state but lose that adhesion after exposure. To achieve this, SULs with groups (or components) that produce high water contact angles (WCAs) before exposure, and low WCA angles after exposure may be used. A common group used to achieve a large change in WCA is tert-butyl esters which switch from hydrophobic to hydrophilic upon deprotection with acid and heat. To this end, a model SUL was prepared via a two-step synthetic process starting from commercially available tert-butyl butenoate. Hydrosilylation of the butenoate with dimethylchlorosilane and a platinum catalyst produced the corresponding alkylsilylchloride which was purified by distillation. Next, subsequent reaction of the silylchloride with an excess of dimethylamine and purification by filtration and evaporation of the solvent produced tert-butyl 4-[dimethylamino(dimethyl)silyl]butanoate as a slight yellow oil. This silylamide was dissolved in PGMEA at a 1% concentration and spin-coated onto wafers with an exposed silicon oxide layer. After spin-coating, the wafer was baked at 110 °C for 1 min to promote surface grafting. The wafer was then rinsed with fresh PGMEA to remove any unreacted byproducts. Successful formation of the SUL was confirmed by ellipsometry and water contact angle (WCA) measurement. A prototypical CAR containing polytertbutylmethacrylate-parahydroxystyrene copolymers, triphenyl sulfonium perfluoro-1-butanesufonate (photoacid generator) and trioctylamine (quencher) was deposited onto this SUL. After carrying out the typical lithographic process (EUV exposure, PEB and development) on this wafer, a low WCA was observed in the exposed areas indicating successful deprotection of the tert-butyl ester on the SUL to form the deprotected carboxylic acid.

Example 1 is a method of forming a structure comprising a photoresist underlayer. The method includes: (1) providing a substrate, (2) grafting a chemically amplified resist (CAR) switchable underlayer (SUL) to a surface of the substrate, the SUL having SUL molecules each with a grafting component to graft the SUL molecule to the substrate surface, (3) depositing a CAR layer onto the SUL, wherein the SUL molecules each have a resist adhesion component that adheres with the CAR, (4) performing an EUV scan operation on the CAR, wherein portions of the CAR are exposed to EUV radiation, and (5) performing a post-exposure bake (PEB) operation to the SUL and CAR, wherein the resist adhesion components are switched to being inactive, making the CAR less adhesive with the SUL.

Example 2 includes the subject matter of example 1, and further comprising developing the CAR by washing away the exposed CAR residing over the switched SUL.

Example 3 includes the subject matter of any of examples 1 and 2, and wherein the substrate surface is a silicon oxide surface.

Example 4 includes the subject matter of any of examples 1-3, and wherein the grafting component is selected from a group consisting of silyl amides, silyl chlorides, trialkoxy silanes, phosphonates and alcohols.

Example 5 includes the subject matter of any of examples 1-4, and wherein grafting includes depositing the SUL using a vapor phase deposition (VPD) process.

Example 6 includes the subject matter of any of examples 1-5, and wherein grafting includes depositing the SUL using a spin coat deposition process.

Example 7 includes the subject matter of any of examples 1-6, and further comprising baking the spin-coated SUL prior to depositing onto it the CAR.

Example 8 includes the subject matter of any of examples 1-7, and wherein the resist adhesion component is selected from a group consisting of alkanes, pefluoroalkanes, aryl groups, polygylcols and polymers.

Example 9 includes the subject matter of any of examples 1-8, and wherein the resist adhesion components are switched to being less adhesive by removing them from the SUL molecules using photoacids generated by the CAR.

Example 10 includes the subject matter of any of examples 1-9, and wherein the resist adhesion components are switched to being less adhesive by removing them from the SUL molecules using photoacids generated within the SUL.

Example 11 includes the subject matter of any of examples 1-10, and wherein the post exposure bake is at a temperature of between 115 and 125 degrees C for a period of between 30 and 120 seconds.

Example 12 includes the subject matter of any of examples 1-11, and wherein the SUL molecules each include a scum elimination component that is selected from a group consisting of carboxylates, amides, alcohols, thiols, amines and polymers.

Example 13 includes the subject matter of any of examples 1-12, and wherein the SUL molecules each have a PEB activation-temperature control component selected from a group consisting of aryl and heteroaryl rings substituted with electron donating substituents or electron withdrawing substituents.

Example 14 is a resistive underlayer compound that includes a grafting group component, a resist adhesion component, and a scum elimination control component. The grafting group component is to graft an underlayer to a wafer surface. The resist adhesion component has adhesive head groups to adhere to a chemically amplified resist (CAR). The scum elimination control component is less adhesive to the CAR than the resist adhesive component, and the scum elimination component is blocked from the CAR by the adhesive head groups prior to the CAR being exposed to EUV radiation and is available to be in contact with the CAR when the head groups are removed by a photoacid generated by the EUV radiation.

Example 15 includes the subject matter of example 14, and further comprising a post exposure bake (PEB) control component to control when the head groups are removed by the photoacid.

Example 16 includes the subject matter of any of examples 14-15, and wherein the PEB control component controls the head groups to be removed during a PEB at a temperature of between 115 and 125 degrees C for a period of between 30 and 120 seconds.

Example 17 includes the subject matter of any of examples 14-16, and wherein the PEB control component is selected from a group consisting of aryl and heteroaryl rings substituted with electron donating substituents or electron withdrawing substituents.

Example 18 includes the subject matter of any of examples 14-17, and wherein the grafting component will anchor the underlayer to a silicon oxide wafer surface.

Example 19 includes the subject matter of any of examples 14-18, and wherein the grafting component is selected from a group consisting of silyl amides, silyl chlorides, trialkoxy silanes, phosphonates and alcohols.

Example 20 includes the subject matter of any of examples 14-19, and wherein the resist adhesion component is selected from a group consisting of alkanes, pefluoroalkanes, aryl groups, polygylcols and polymers.

Example 21 includes the subject matter of any of examples 14-20, and further including a photoacid generator to produce the photoacid from incident photons from EUV radiation.

Example 22 includes the subject matter of any of examples 14-21, and wherein the scum elimination component is selected from a group consisting of carboxylates, amides, alcohols, thiols, amines and polymers.

Example 23 is a resistive underlayer compound that includes a resist adhesion component, a scum elimination control component, and an activation temperature control component. The resist adhesion component has adhesive heads to adhere to a chemically amplified resist (CAR). The scum elimination control component that is less adhesive to the CAR than the resist adhesive component, the scum elimination component being blocked from the CAR prior to the CAR being exposed to EUV radiation and in contact with the CAR when the heads are de-protected by a photoacid generated by the EUV radiation. The activation temperature control component controls when the heads are de-protected by the photoacid.

Example 24 includes the subject matter of example 23, and wherein the PEB control component controls the heads to be de-protected during a PEB at a temperature of between 100 and 130 degrees C.

Example 25 includes the subject matter of any of examples 23-24, and wherein the PEB control component is selected from a group consisting of aryl and heteroaryl rings substituted with electron donating substituents or electron withdrawing substituents.

Example 26 includes the subject matter of any of examples 23-25, and further comprises a grafting component to anchor the underlayer to a silicon oxide wafer surface.

Example 27 includes the subject matter of any of examples 23-26, and wherein the grafting component is selected from a group consisting of silyl amides, silyl chlorides, trialkoxy silanes, phosphonates and alcohols.

Example 28 includes the subject matter of any of examples 23-27, and wherein the resist adhesion component is selected from a group consisting of alkanes, pefluoroalkanes, aryl groups, polygylcols and polymers.

Example 29 includes the subject matter of any of examples 23-28, and further includes a photoacid generator to produce the photoacid from incident photons from EUV radiation.

Example 30 includes the subject matter of any of examples 23-29, and wherein the scum elimination component is selected from a group consisting of carboxylates, amides, alcohols, thiols, amines and polymers.

### Alt Embodiments

The example embodiments of the disclosure described above do not limit the scope of the invention, since these embodiments are merely examples of the embodiments of the invention. Any equivalent embodiments are intended to be within the scope of this invention. Indeed, various modifications of the disclosure, in addition to the embodiments shown and described herein, such as alternative useful combinations of the elements described, may become apparent to those skilled in the art from the description. Such modifications and embodiments are also intended to fall within the scope of the appended claims.

As used in this specification, the term "embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

The example embodiments of the disclosure described above do not limit the scope of the invention, since these embodiments are merely examples of the embodiments of the invention. Any equivalent embodiments are intended to be within the scope of this invention. Indeed, various modifications of the disclosure, in addition to the embodiments shown and described herein, such as alternative useful combinations of the elements described, may become apparent to those skilled in the art from the description. Such modifications and embodiments are also intended to fall within the scope of the appended claims.

## Claims

1. A resistive underlayer compound, comprising:
a grafting group component to graft an underlayer to a wafer surface;
a resist adhesion component having adhesive head groups to adhere to a chemically amplified resist (CAR); and
a scum elimination control component that is less adhesive to the CAR than the resist adhesive component, the scum elimination component being blocked from the CAR by the adhesive head groups prior to the CAR being exposed to EUV radiation and available to be in contact with the CAR when the head groups are removed by a photoacid generated by the EUV radiation.

2. The compound of claim 1, further comprising a post exposure bake (PEB) control component to control when the head groups are removed by the photoacid.

3. The compound of claim 2, wherein the PEB control component controls the head groups to be removed during a PEB at a temperature of between 115 and 125 degrees C for a period of between 30 and 120 seconds.

4. The compound of claim 3, wherein the PEB control component is selected from a group consisting of aryl and heteroaryl rings substituted with electron donating substituents or electron withdrawing substituents.

5. The compound in accordance with any of claims 1-4, wherein the grafting component will anchor the underlayer to a silicon oxide wafer surface.

6. The compound in accordance with any of claims 3-5, wherein the grafting component is selected from a group consisting of silyl amides, silyl chlorides, trialkoxy silanes, phosphonates and alcohols.

7. The compound in accordance with any of claims 1-6, wherein the resist adhesion component is selected from a group consisting of alkanes, pefluoroalkanes, aryl groups, polygylcols and polymers.

8. The compound in accordance with any of claims 1-7, further including a photoacid generator to produce the photoacid from incident photons from EUV radiation.

9. The compound in accordance with any of claims 1-8, wherein the scum elimination component is selected from a group consisting of carboxylates, amides, alcohols, thiols, amines and polymers.

10. A method of forming a structure comprising a photoresist underlayer, the method comprising:
providing a substrate;
grafting a chemically amplified resist (CAR) switchable underlayer (SUL) to a surface of the substrate, the SUL having SUL molecules each with a grafting component to graft the SUL molecule to the substrate surface;
depositing a CAR layer onto the SUL, wherein the SUL molecules each have a resist adhesion component that adheres with the CAR;
performing an EUV scan operation on the CAR, wherein portions of the CAR are exposed to EUV radiation; and
performing a post-exposure bake (PEB) operation to the SUL and CAR, wherein the resist adhesion components are switched to being inactive, making the CAR less adhesive with the SUL.

11. The method of claim 10, further comprising developing the CAR by washing away the exposed CAR residing over the switched SUL.

12. The method in accordance with any of claims 10-11, wherein the substrate surface is a silicon oxide surface.

13. The method of claim 12, wherein the grafting component is selected from a group consisting of silyl amides, silyl chlorides, trialkoxy silanes, phosphonates and alcohols.

14. The method in accordance with any of claims 10-13, wherein grafting includes depositing the SUL using a vapor phase deposition (VPD) process.

15. The method in accordance with any of claims 10-14, wherein grafting includes depositing the SUL using a spin coat deposition process.
